# EUROPEAN PATENT APPLICATION

(11) **EP 2 244 313 A1**
(43) Date of publication of application: **27.10.2010**
(21) Application number: 09164091.2
(22) Date of filing: 30.06.2009
(51) Int. Cl.: H01L 33/64, H01L 33/48, H01L 33/62

(54) **Light emitting diode with high power**

(30) Priority: 21.04.2009 CN 200910106764
(71) Applicant: Xue, Xinpei, Qidong Jiangsu (CN); Xue, Xinshen, Shenzhen (CN)
(72) Inventor: Xue, Xinpei, Qidong Jiangsu (CN); Xue, Xinshen, Shenzhen (CN)
(74) Representative: Beetz & Partner

(57) **Abstract**

A light emitting diode includes a base, a dispersing member, a chip, a pole, a cover, an electrode, and a lens. The base is capable of conducting heat and insulated from electricity. The base has a first surface and a second surface opposite to the first surface. The dispersing member is disposed on a first surface of the base. The chip is disposed on a second surface of the base. The pole runs through the base, and two ends of the pole are connected to the dispersing member and the chip correspondingly. The cover to allow light to run therethrough is disposed on the second surface of the base and covers the chip. The electrode is disposed on the second surface the base and electrically connected to a circuit inside the base. The circuit electrically connected to the chip. The lens seals the cover.

## Description

### CROSS-REFERENCE TO RELATED PATENT APPLICATION

This application claims priority of Chinese Patent Application Nos. 200910106764.8, filed on Apr. 21, 2009, the disclosure of which is incorporated herein in its entirety by reference.

### FIELD OF THE INVENTION

The present disclosure generally relatives to semiconductor lighting devices and, particularly, to a LED with high power.

### BACKGROUND OF THE INVENTION

LEDs, as a new kind of light source, have characteristics of small volume, low energy consumption, good compatibility, high reliability, quick responding, anti-vibration, non-pollution to environment, and emitting various of colors etc. Therefore, LEDs are widely used in lighting and ornamenting field. LEDs with high power have characteristics of high lumen efficiency, saving energy, and protecting environmental etc.

A typical LED, with high power or secondary high power, usually has a bracket type structure including plug-in type, and surface mounted type. However, the LED, with structure of above-described types, attenuates quickly, cannot disperse heat efficiently, has bad sealing performance, and low lumen efficiency. Thus, LEDs are baffled to be used in lighting field.

Therefore, a new LED with high power is desired to overcome the above-described shortcomings.

### SUMMARY OF THE INVENTION

A light emitting diode comprises a base, a dispersing member, a chip, a pole, a cover, an electrode, and a lens. The base is capable of conducting heat and insulated from electricity. The base has a first surface and a second surface opposite to the first surface. The dispersing member is disposed on a first surface of the base. The chip is disposed on a second surface of the base. The pole runs through the base, and two ends of the pole are connected to the dispersing member and the chip correspondingly. The cover to allow light to run therethrough is disposed on the second surface of the base and covers the chip. The electrode is disposed on the second surface the base and electrically connected to a circuit inside the base. The circuit electrically connected to the chip. The lens seals the cover.

### BRIEF DESCRIPTION OF THE DRAWINGS

The components in the drawings are not necessarily drawn to scale, the emphasis instead being placed upon illustrating the principles of the present disclosure. Moreover, in the drawings, like reference numerals designate corresponding parts throughout several views, and all the views are schematic.

FIG. 1 is an exploded, isometric view of an embodiment of a LED of the present disclosure.

FIG. 2 is an assembled, isometric view of the LED of FIG. 1.

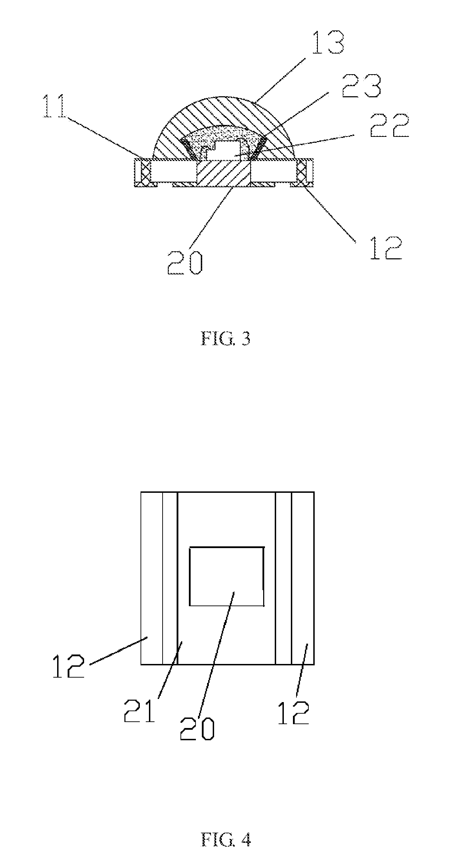

FIG. 3 is a cross-sectional view of FIG. 2.

FIG. 4 is a bottom view of the LED of FIG. 2.

### DETAILED DESCRIPTION OF THE INVENTION

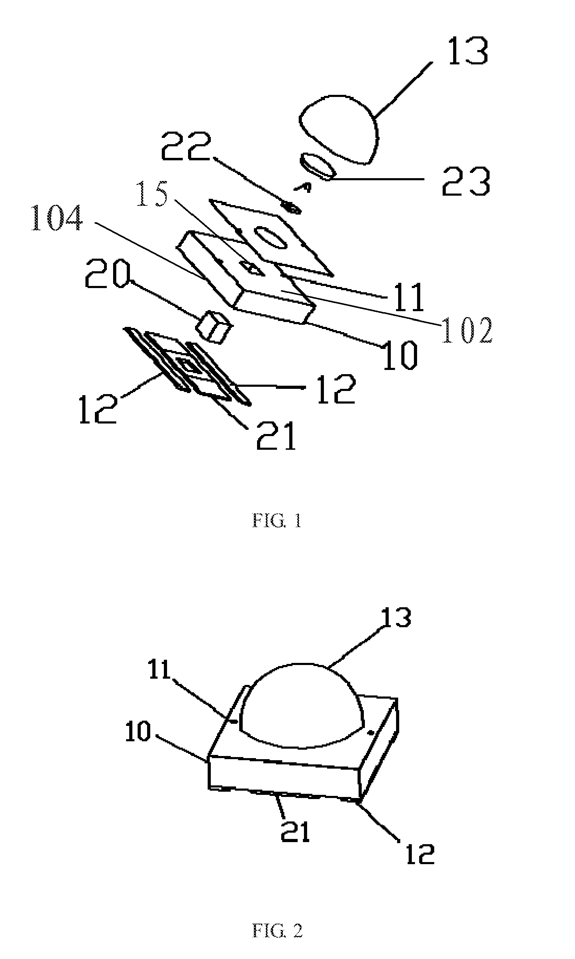

Referring to FIG. 1, an embodiment of a LED of the present disclosure is shown. The LED includes a base 10, two electrodes 12, a lens 13, a pole 20, a dispersing member 21 for dispersing heat, a chip 22, and a cover 23. The base 10 can conduct heat, and insulates from electricity. The base 10 is made of material with high heat conductivity and quite low electrical conductivity, such as aluminum nitride, ceramics and silicon. The pole 20 can conduct heat. The cover 23 is transparent to allow light passing through.

The base 10 includes a top surface 102 and a bottom surface 104 opposite to the top surface 102. The base 10 defines two through holes11 adjacent to an edge of the base 10. Circuit is disposed in the base 10. The circuit runs through the through holes 11 of the base 10. The base 10 further defines a receiving hole 15 for receiving the pole 20. The top surface 102 of the base 10 is coated with a light reflecting film, such as alumina film. The light reflecting film is configured to reflect light from a bottom of the chip 22 towards the cover 23, so as to promote a luminescence efficiency of the LED. The cover 23 is made of transparent material such as glass and acryl.

The electrodes 12 are disposed on the bottom surface 104 of the base 10. Circuit runs through the through holes 11 to electrically connected to the electrodes 12 and exposes to the top surface 102 of the base 10 to electrically connected to the chip 22.

The dispersing member 21 is disposed on the bottom surface 104 of the base 10 so that heat generated by the chip 22 can be dispersed quicker. The dispersing member 21 defines a through hole. The pole 20 has a thickness substantially the same as the base 10. The pole 20 is received in the receiving hole 15 of the base 10 and the through hole of the dispersing member 21. The pole 20 transfers heat generated by the chip 22 to the dispersing member 21 so that the heat can be dispersed quickly. The pole 20 is made of material with high heat conductivity such as copper, silver, and alloy.

The chip 22 is mounted on the pole 20. The cover 23 covers the chip 22. The cover 23 is a conical-shaped frame with a smaller end adjacent to the pole 20. A surface of the cover 23 is coated with fluorescent powder. An inner surface of a top portion of the cover 23 is dealed with a particular method so that the inner surface is smooth and has no capillary phenomenon. Capillary phenomenon may result in uniformity of light, consistency of a batch of LEDS. The uniformity of light and inconsistent LEDs may result in bad appearance of LEDs.

The lens 13 is mounted on the substrate 14 and packages the chip 22 and the cover 23 therein. The lens 13 is made of silica gel with nice conductivity. The lens 13 is integrally formed on the base 10. The lens 13 has two functions. One function acts as a lens and formed to different shapes, so as to obtain different lighting effects, for example a light angle of the LED. The other function is to seal and protect the chip 22, so that the chip 22 and fluorescent powder cannot be oxidized or damaged. The lens 13 is a hemisphere in the illustrated embodiment.

Since the pole 20 is made of material with high heat conductivity and connected to the dispersing member 21, heat generated by the chip 22 can be dispersed quickly. Therefore, chip 22 can be ensured to work steadily. Since the base 10 is made of material with high heat conductivity and quite low electrical conductivity, such as aluminum nitride, ceramics and silicon, circuit and electrode may be formed on the base 10 directly. Therefore, the base 10 has low cost. The base 10 is a flat board, so that a lighting angle of the chip 22 is very large and an luminous efficiency of the LED is high. Since the circuit runs through the through holes 11 to connected to the electrodes 12 on the bottom surface 104, the heat conducting part and the electrical conducting part are spaced from each other to promote a stability of the LED. The lens 13 has nice stability and heat dispersing performance for made of silica gel. The LED has nice reliability and consistency. When the LEDs made with machine, a production efficiency is high and a manufacturing cost is low.

Finally, while various embodiments have been described and illustrated, the disclosure is not to be construed as being limited thereto. Various modifications can be made to the embodiments by those skilled in the art without departing from the true spirit and scope of the disclosure as defined by the appended claims.

## Claims

1. A light emitting diode, comprising:
a base capable of conducting heat and insulated from electricity, the base having a first surface and a second surface opposite to the first surface;
a dispersing member disposed on a first surface of the base;
a chip disposed on a second surface of the base;
a pole running through the base, two ends of the pole connected to the dispersing member and the chip correspondingly;
a cover to allow light to run therethrough disposed on the second surface of the base and covering the chip;
an electrode disposed on the second surface the base and electrically connected to a circuit inside the base, the circuit electrically connected to the chip; and
a lens sealing the cover.

2. The light emitting diode as claimed in claim 1, wherein the light emitting diode comprises two electrodes spaced from each other.

3. The light emitting diode as claimed in claim 2, wherein the base defines two through holes to allow the circuit positioned therethrough to contact with the electrodes.

4. The light emitting diode as claimed in claim 2, wherein the electrodes are spaced from the pole.

5. The light emitting diode as claimed in claim 4, wherein the cover is conical-shaped with a smaller end adjacent to the pole and a larger end adjacent to the lens; a surface of the cover is coated with fluorescent powder, and an inner surface of a top portion of the cover is smooth and has no capillary phenomenon.

6. The light emitting diode as claimed in claim 1, wherein the second surface of the base is coated with a light reflecting film.

7. The light emitting diode as claimed in claim 1, wherein the lens is made of silica gel.

8. The light emitting diode as claimed in claim 1, wherein the pole is a cuboid.

9. The light emitting diode as claimed in claim 8, wherein the elastic member is a compression spring.
